# EUROPÄISCHE PATENTSCHRIFT

(11) **EP 3 830 894 B1**
(45) Veröffentlichungstag und Bekanntmachung des Hinweises auf die Patenterteilung: **04.09.2024**
(21) Anmeldenummer: 19748816.6
(22) Anmeldetag: 31.07.2019
(51) Int. Cl.: H01P 5/08, H01Q 1/22, G01F 23/284, G01S 7/03, H01P 5/02, H01P 5/107

(54) **HOCHFREQUENZBAUSTEIN**
HIGH-FREQUENCY COMPONENT
MODULE À HAUTE FRÉQUENCE

(30) Priorität: 02.08.2018 DE 102018118765
(43) Veröffentlichungstag der Anmeldung: 09.06.2021
(73) Patentinhaber: Endress+Hauser SE+Co. KG, 79689 Maulburg (DE)
(72) Erfinder: HITZLER, Martin, 89075 Dillingen (DE); MAYER, Winfried, 89290 Buch (DE)
(74) Vertreter: Koslowski, Christine Adelheid
(86) Internationale Anmeldenummer: PCT/EP2019/070661
(87) Internationale Veröffentlichungsnummer: WO 2020/025690

(56) Entgegenhaltungen:
- DE-A1- 102015 112 861
- JP-A- 2002 208 807
- US-A1- 2006 274 992
- US-A1- 2011 234 466
- US-A1- 2012 188 030
- US-A1- 2012 242 427
- US-A1- 2014 111 394
- US-A1- 2017 324 135
- TAN DUNLIN ET AL: "Carbon nanotubes based RF packaging solutions", 2018 IEEE 18TH INTERNATIONAL CONFERENCE ON NANOTECHNOLOGY (IEEE-NANO), IEEE, 23 July 2018 (2018-07-23), pages 1 - 4, XP033513025, DOI: 10.1109/NANO.2018.8626279

## Beschreibung

Die Erfindung betrifft einen Hochfrequenzbaustein zur Erzeugung bzw. Verarbeitung von Radar-Signalen, der insbesondere zum Einsatz bei Radar-basierten Füllstandsmessgeräten gedacht ist.

Radar-basierte Abstandsmessung wird in einem breiten Anwendungsspektrum genutzt. Entsprechende Abstandsmessgeräte werden beispielsweise zur Positionsbestimmung in der Luftfahrt, zur Abstandsmessung bei Kraftfahrzeugen oder zur Füllstandsmessung in der Prozessautomation industrieller Anlagen eingesetzt. Als Messverfahren ist neben dem Puls-Laufzeit-Verfahren überwiegend das FMCW-Verfahren (*"Frequency Modulated Continuos Wave*", auch bekannt als Dauerstrichradar) implementiert. Beide Verfahren werden bei definierten Radar-Frequenzen bzw. innerhalb definierter Frequenzbänder betrieben (im Rahmen dieser Erfindung beziehen sich die Begriffe "Radar" und "Hochfrequenz" auf elektrische Signale bzw. elektromagnetische Wellen mit Frequenzen zwischen 0.03 GHz und 300 GHz). Das Funktionsprinzip von FMCW- und Pulsradarbasierten Füllstandsmessgeräten wird beispielsweise in *"*Radar Level Measurement"; Peter Devine, 2000 beschrieben.

Im Bereich der Füllstandsmessung wird vorwiegend bei Radar-Frequenzen von 6 GHz, 26 GHz oder 79 GHz gearbeitet. Dabei sind zumindest bei FMCW höhere Frequenzbänder insofern bevorzugt, als dass eine größere absolute Frequenz-Bandbreite genutzt werden kann. Bei 79 GHz wird beispielsweise eine Bandbreite von 2 GHz genutzt, also von 78 GHz bis 80 GHz. Durch eine höhere Bandbreite kann wiederum eine höhere Auflösung der Abstandsmessung erreicht werden. Insbesondere bei der Füllstandsmessung stellt dies eine wichtige Anforderung dar, da je nach Anwendung eine möglichst genaue Kenntnis des Füllstandes erforderlich ist. Ein weiterer Vorteil bei der Verwendung hoher Frequenzen besteht darin, dass das Radar-basierte Abstandsmessgerät mit einer kompakteren Antenne ausgestattet werden kann, ohne dass die Bündelungs-Wirkung der Antenne vermindert wird. Bei Füllstandsmessung werden dadurch beispielsweise verkleinerte Anschluss-Flansche zur Anbringung am Behälter möglich. Daher ist es erstrebenswert, Füllstands- bzw. Abstandsmessung im Allgemeinen auch bei höheren Frequenzen als 79 GHz (bis hin zu Radarfrequenzen von 300 GHz) zu betreiben.

Radar-Signale bei Frequenzen von über 100 GHz können zwischen dem Halbleiterbauteil, mit dem das entsprechende elektrische Hochfrequenz-Signal erzeugt wird, und der Leiterkarte, auf dem das Halbleiterbauteil platziert ist, nicht mehr über hybride Verbindungstechnologien geführt werden. Da die Dimensionen der Verbindungsstrukturen wie Bonddrähte oder Lötstellen zu den jeweiligen elektronischen Bauteilen in der Größenordnung der Wellenlänge der Radar-Signale liegen, stören diese Verbindungsstrukturen als parasitäre Elemente das Übertragungsverhalten. Darüber hinaus verursachen viele der in der Elektronik üblichen Werkstoffe mit der Frequenz steigende Verluste, durch welche die elektrischen Hochfrequenz-Signale schon über kurze Leitungs-Distanzen erheblich gedämpft werden. Die leistungsfähige und zuverlässige Kontaktierung des Halbleiterbauteils mittels hybrider Standardtechnologien ist aus diesem Grund mit zunehmender Frequenz schwierig.

Daher werden zur Erzeugung bzw. zum Empfang von Radar-Signalen insbesondere oberhalb von 60 GHz Halbleiterbauteile eingesetzt, von denen das elektrische Hochfrequenz-Signal unmittelbar als Radar-Signal abgestrahlt werden kann, bzw. mit denen eingehende Radar-Signale unmittelbar in entsprechende elektrische Hochfrequenz-Signale umwandelbar sind. Somit ist eine hybride Signalführung nicht mehr erforderlich. Die Abstrahlung und/oder die Einkopplung der Radar-Signale erfolgt in diesem Fall über einen endsprechenden Primärstrahler. Dabei handelt es sich beispielsweise um eine Planar-Antenne, die mittels mikromechanischer Verfahren auf dem Halbleiterbauteil aufgebracht ist. Ein solches Halbleiterbauteil wird unter anderem in der Veröffentlichungsschrift DE 10 2015 119 690 A1 beschrieben. Somit wird vermieden, dass die elektrischen Hochfrequenz-Signale über externe Leiterbahnen, Lötverbindungen oder Bonddrähte geführt werden müssen. Dies vermindert gerade bei hohen Frequenzen die Leistungsfähigkeit und Störanfälligkeit des Abstandsmessgerätes.

Vorteilhaft an einer monolithischen Realisierung ist zudem, dass sowohl die SignalErzeugung als auch die Signal-Auswertung im gleichen Halbleiterbauteil realisiert werden können. Hierzu können je nach Messverfahren bekannte Schaltungskomponenten implementiert werden: Im Fall von FMCW kann das Hochfrequenz-Signal für das auszusendende Radar-Signal mittels einer PLL ("*Phase Locked Loop*") erzeugt werden; Das empfangene Radar-Signal kann per Mischer mit dem auszusendenden Hochfrequenz-Signal gemischt werden, so dass aus der so genannten Differenz-Frequenz des gemischten Signals der Abstand bzw. Füllstand ermittelt werden kann. Ein entsprechend ausgelegter Auswertungsblock kann die Differenz-Frequenz beispielsweise mittels einer FFT (*"Fast Fourier Transformation*") des gemischten Signals ermitteln.

Damit das Halbleiterbauteil Radar-Signale effizient aussenden und einkoppeln kann, muss das Gehäuse des Halbleiterbauteils hierfür entsprechend gekapselt sein. Ein komplettes Umschließen des Halbleiterbauteils mittels Spritzguss, wie es bspw. standardmäßig bei SMD-Bauteilen (*"Surface Mount Device*") erfolgt, ist nicht möglich, da hierdurch die Radar-Signale gedämpft bzw. vollständig absorbiert werden können. In der Patentschrift US 9583811 B2 wird beispielsweise ein Halbleiterbauteil beschrieben, das geeignet gekapselt ist, um Hochfrequenz-Signale als Radar-Signale in einen Hohlleiter einzukoppeln. Dazu ist am Halbleiterbauteil ein Koppelelement angeordnet, wobei die dortige Kapselung einen integrierten Hohlleiter umfasst, der galvanisch getrennt in einem definierten Abstand über dem Koppelelement angeordnet ist. Um den Hohlleiter in Bezug zum Halbleiterbauteil richtig zu positionieren, ist jedoch gegebenenfalls eine entsprechend aufwendige Justage bei der Anbringung der Kapselung erforderlich.

In der Patentschrift US 2006/274992 A1 wird ein induktiv von einem Halbleiterbauteil gespeistes Koppelelement, das wiederum einen in 90° dazu angeordneten Hohlleiter über Koppelschlitze speist.

In der US-Veröffentlichungsschrift 20120188030 A1 wird ein Koppelelement zur Kopplung von Hochfrequenz-Signalen zwischen einem Halbleiterbauteil und einem rechteckigen Hohlleiter beschrieben. Hierzu basiert das Koppelelement auf einer Leiterplatte mit einer zum Hohlleiter korrespondierenden Durchführung. Dabei grenzt an einer Oberfläche der Leiterplatte an die Durchführung ein Hochfrequenz-reflektierender Endbereich an. An der gegenüberliegenden Oberfläche der Leiterplatte grenzt der Hohlleiter an die Durchführung an. Eingekoppelt wird das Hochfrequenz-Signal vom Koppelelement in den Hohlleiter entweder über elektrische Durchführungen in der Leiterplatte, die korrespondierend zum Querschnitt des Hohlleiters entlang einer quasi geschlossenen Kontur angeordnet sind, oder über eine zentral in die Durchführung hineinragenden Mikrostreifenleitung.

Ein Koppelelement, das ebenfalls auf einer mehrlagigen Leiterplatte basiert und eine zentrale Mikrostreifenleitung zum Einkoppeln de Hochfrequenz-Signale in einen Wellenleiter umfasst, wird in der Veröffentlichungsschrift JP 2002 208807 A beschrieben. Ein Hochfrequenzbaustein mit einem Substrat-integrierten Wellenleiter als Koppelelement ist in der Veröffentlichungsschrift US 20120242427 A1 gezeigt. Dort wird das Hochfrequenz-Signal innerhalb des Koppelelementes durch eine reihige Anordnung von metallisierten Vias in der Ebene der Leiterplatte geführt.

Die Veröffentlichung von Tan Dunlin et al: "Carbon nanotubes based RF packaging solutions",2018 IEEE 18TH INTERNATIONAL CONFERENCE ON NANOTECHNOLOGY (IEEE-NANO), IEEE, 23. Juli 2018, Seiten 1-4,DOI: 10.1109/NANO.2018.8626279 offenbart einen induktiv gespeisten "Substrat Integrierten Wellenleiter", dessen Wände aus Kohlenstoff-Nano-Röhrchen gebildet sind.

Der Erfindung liegt die Aufgabe zugrunde, einen einfach zu fertigenden Hochfrequenzbaustein zur Verfügung zu stellen, mit dem Radar-Signale effizient aus- und eingekoppelt werden können. Die Erfindung löst diese Aufgabe durch einen Hochfrequenzbaustein entsprechend Anspruch 1.

Dabei definiert sich der galvanische Kontakt im Rahmen der Erfindung als elektrische Kontaktierung zwischen dem elektrisch leitenden Inneren des Hohlleiters und der korrespondierenden elektrischen Leiterstruktur des elektrischen Hochfrequenz-Signals auf dem Koppelelement.

Vorteilhaft hieran ist, dass kein definierter Abstand bzw. keine definierte Position des Hohlleiters zum Koppelelement eingestellt werden muss, um eine effiziente Aus- und Einkopplung des Hochfrequenz-Signals in den Hohlleiter zu erzielen, da dies bereits durch entsprechende Auslegung des Koppelelementes erreicht wird. Somit wird die Montage des Hochfrequenzbausteins vereinfacht.

Trotz des galvanischen Kontaktes zwischen dem Hohlleiter und dem Koppelelement kann eine mechanische Beanspruchung des empfindlichen Halbleiterbauteils durch den Hohlleiter unterdrückt werden. Hierzu ist es von Vorteil, wenn das Koppelelement eine Dicke von zumindest 200 µm aufweist.

Zur elektrischen und/oder mechanischen Kontaktierung des Koppelelementes kann auf bekannte Aufbau- und Verbindungstechnologien zurückgegriffen werden. Beispielsweise können das Halbleiterbauteil und das Koppelelement zur Einkopplung der Hochfrequenz-Signale mittels einer Lötverbindung, beispielsweise in Form eines Ball Grid Arrays, kontaktiert werden. Auch eine etwaige Kapselung des Halbleiterbauteils kann mit bekannten Technologien wie bspw. einer Vergusskapselung erfolgen. Allerdings ist das Halbeiterbauteil derart zu kapseln, dass die galvanische Kontaktfläche des Koppelelementes hin zum Hohlleiter frei von Verguss ist.

Im Rahmen der Erfindung kann das Koppelelement prinzipiell auf den Materialien und Fertigungsverfahren für Leiterplatten aufgebaut sein. Dementsprechend kann das Koppelelement aus einem Substrat, insbesondere einem Glass- oder Keramik-basierten Substrat, gefertigt werden. Dabei ist der Durchmesser der Durchkontaktierungen je nach Fertigungsverfahren prinzipiell beliebig einstellbar. Bei den gängigen Laserbohr- und Metallisierungs-Verfahren beträgt der Durchmesser weniger als 250µm. Mittels speziellen Verfahren wie dem so genannten "Glass-Prozess", bei dem das Koppelelement auf Glas-Basis aufgebaut ist, können auch kleine Durchmesser zwischen 40 µm und 80 µm erreicht werden.

Zu einer einfachen Fertigung des Hochfrequenzbausteins ist es vorteilhaft, wenn eine Leiterplatte als Substrat zur Anordnung der weiteren Komponenten (Halbleiterbauteil, Koppelelement und Hohlleiter) des Hochfrequenzbausteins dient. Dabei ist jedoch die Anordnung dieser Komponenten untereinander nicht fest vorgeschrieben. So kann der erfindungsgemäße Hochfrequenzbaustein bspw. aufgebaut werden, indem das Halbleiterbauteil (entweder direkt als *"Bare Die"* oder indirekt über den Leadframe des gekapselten Halbleiterbauteils) auf einer Oberfläche dem Leiterplattensubstrat angeordnet ist, wobei der Hohlleiter auf der gleichen Oberfläche des Leiterplattensubstrates befestigt ist. Dabei ist das Koppelelement auf derjenigen Oberfläche des Halbleiterbauteils angeordnet, die dem Leiterplattensubstrat abgewandt ist. In diesem Fall kann der Hohlleiter als ggf. zusätzliche Kapselung des Halbleiterbauteils und des oberhalb befindlichen Koppelelementes fungieren, bspw. wenn der Hohlleiter in einen entsprechenden Deckel eingefasst ist. Ein solcher Deckel kann beispielsweise wiederum durch Spritzgussverfahren gefertigt sein.

Eine alternative Möglichkeit zur Anordnung der Komponenten (Halbleiterbauteil, Koppelelement und Hohlleiter) zueinander besteht darin, dass das Koppelelement auf einer ersten Oberfläche des Leiterplattensubstrates angeordnet ist. Sofern in diesem Fall das Halbleiterbauteil auf einer dem Leiterplattensubstrat abgewandten Oberfläche des Koppelelementes angeordnet wird, kann der Hohlleiter auf einer zweiten, dem Koppelelement abgewandten Oberfläche des Leiterplattensubstrates befestigt werden. Hierbei ist der Hohlleiter jedoch über eine Öffnung in der Leiterplatte galvanisch mit dem Koppelelement zu kontaktieren. Diese Möglichkeit der Anordnung bietet den Vorteil, den Hochfrequenzbaustein sehr flach realisieren zu können.

Eine dritte Möglichkeit zur Anordnung der Komponenten besteht darin, dass das Koppelelement und der Hohlleiter auf der ersten Oberfläche des Leiterplattensubstrates angeordnet sind, während das Halbleiterbauteil auf einer dem Leiterplattensubstrat abgewandten Oberfläche des Koppelelementes angeordnet ist. Bei dieser Ausführungsvariante bietet sich der spezielle Vorteil, dass das Halbleiterbauteil bei der galvanischen Kontaktierung des Hohlleiters am Koppelelement keinerlei Druck erfährt und somit sehr unkritisch zu fertigen ist.

Abhängig von der Anordnung der Komponenten kann es zwecks geeigneter Fertigbarkeit von Vorteil sein, zunächst die elektrische bzw. mechanische Kontaktierung des Koppelelementes an dem Halbleiterbauteil vorzunehmen, bevor die galvanische Kontaktierung des Hohlleiters am Koppelelement erfolgt. Unabhängig davon, ob das Halbleiterbauteil auf einem Leiterplattensubstrat angeordnet ist, bietet sich diese Fertigungs-Variante vor allem an, wenn jeweils das Koppelelement oberhalb des Halbleiterbauteils, und der Hohlleiter oberhalb des Koppelelementes angeordnet ist. Vorteilhaft wirkt sich die erfindungsgemäße Idee insgesamt dann auf die Fertigbarkeit des Hochfrequenzbausteins aus, sofern das Halbleiterbauteil ausgelegt ist, die Hochfrequenz-Signale mit hohen Frequenzen von 75 GHz oder höher zu erzeugen, da trotz der hohen Frequenzen die einzelnen Strukturen ausreichend groß bemaßt werden können.

Auf Basis des erfindungsgemäßen Hochfrequenzbausteins nach einer der zuvor beschriebenen Ausführungsvarianten kann ein Radar-basiertes Abstandsmessgerät zur Bestimmung eines Abstandes zu einem Messobjekt entsprechend Anspruch 10 aufgebaut werden. Dazu hat es neben dem Hochfrequenzbaustein folgende weitere Komponente zu umfassen:
- eine an den Hohlleiter anschließende Antenne, die ausgelegt ist, die Radar-Signale in Richtung des Messobjektes auszusenden und nach Reflektion am Messobjekt zu empfangen.

Hierfür ist das Halbleiterbauteil so auszulegen, dass es anhand zumindest der reflektierten Radar-Signale den Abstand bestimmen kann. Konkret richtet sich die Auslegung nach dem implementierten Mess-Prinzip, also bspw. FMCW oder dem Puls-Laufzeit-Prinzip. Im Fall von FMCW kann das Halbleiterbauteil zur Erzeugung des Hochfrequenz-Signals eine PLL ("*Phase Locked Loop*") umfassen. Das eingekoppelte Hochfrequenz-Signal kann im Halbleiterbauteil per Mischer mit dem auszusendenden Hochfrequenz-Signal gemischt werden, so dass das Halbleiterbauteil aus der Differenz-Frequenz des gemischten Signals den Abstand ermitteln kann. Ein entsprechend ausgelegter Auswertungsblock des Halbleiterbauteils kann die Differenz-Frequenz beispielsweise mittels einer FFT ("*Fast Fourier Transformation*") des gemischten Signals ermitteln. Bei Verwendung des Puls-Laufzeit-Verfahrens sind analog zu FMCW die nach dem Stand der Technik bekannten Schaltungsbaugruppen bzw. Funktionen im Halbleiterbauteil zu implementieren. Aufgrund der potentiell hohen Frequenzen des auf dem erfindungsgemäßen Hochfrequenzbaustein basierenden Abstandsmessgerätes resultiert eine hohe Auflösung der Abstand-Messung. Daher bietet es sich insbesondere an, ein solches Abstandsmessgerät als Füllstandsmessgerät, das zur Messung des Füllstandes eines in einem Behälter befindlichen Füllgutes dient, entsprechend Anspruch 12 zu verwenden.

Anhand der nachfolgenden Figuren wird die Erfindung näher erläutert. Es zeigt:
Fig. 1: Eine erste Realisierungsvariante des erfindungsgemäßen Hochfrequenzbausteins,
Fig. 2: eine zweite Realisierungsvariante des erfindungsgemäßen Hochfrequenzbausteins,
Fig. 3: eine dritte Realisierungsvariante des erfindungsgemäßen Hochfrequenzbausteins,
Fig. 4: eine mögliche Ausführungsform des Koppelelementes, und
Fig. 5: eine Verwendung des Hochfrequenzbausteins in einem Füllstandsmessgerät.

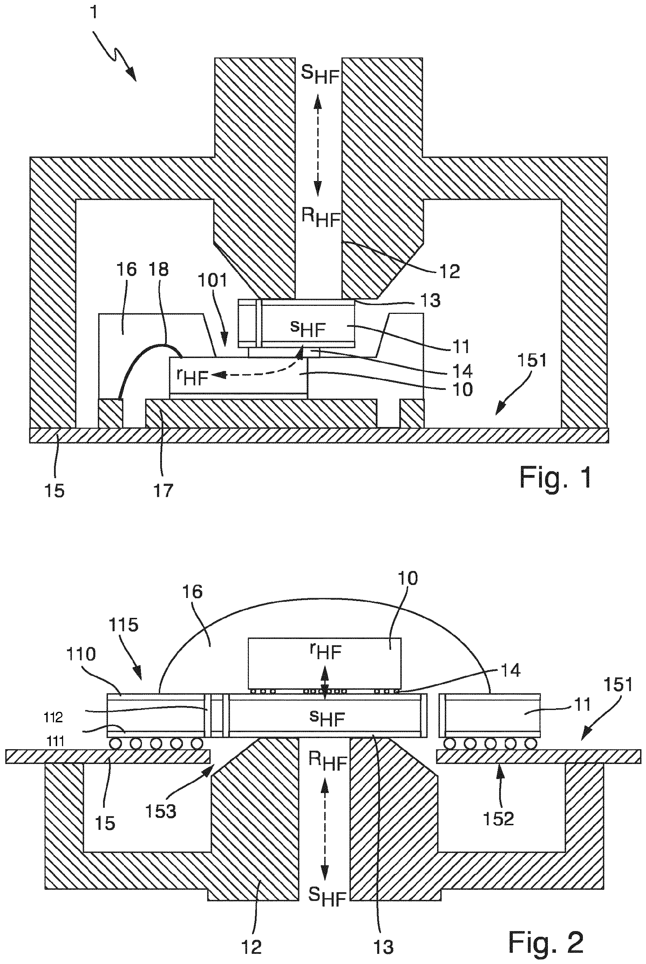

Fig. 1 zeigt eine mögliche Realisierungsvariante eines erfindungsgemäßen Hochfrequenzbausteins 1. Als wesentliche Komponenten umfasst es ein Halbleiterbauteil 10 zur Erzeugung und Verarbeitung von elektrischen Hochfrequenz-Signalen s_{HF}, r_{HF}.

Daneben umfasst der Hochfrequenzbaustein 1 ein Koppelelement 11, das elektrisch mit dem Halbleiterbauteil 10 kontaktiert ist, so dass die Hochfrequenz-Signale s_{HF} als Radar-Signale S_{HF} in einen Hohlleiter 12 einkoppelbar sind, und so die Radar-Signale R_{HF} aus dem Hohlleiter 12 als elektrische Signale r_{HF} in das Halbleiterbauteil 10 eingekoppelt werden können. Dabei ist zwischen dem Koppelelement 11 und dem Hohlleiter 12 ein galvanischer Kontakt 13 ausgebildet.

Bei der in Fig. 1 dargestellten Ausführungsvariante des erfindungsgemäßen Hochfrequenzbausteins 1 ist das Halbleiterbauteil 10 auf einem Leadframe 17 angeordnet und per Vergusskapselung 16 gekapselt, wobei die Kontaktfläche zum Koppelelement 11 hin vom Verguss 16 ausgespart ist. Somit kann das Halbleiterbauteil 10 beispielsweise als entsprechend modifiziertes DIP- (*"Dual In-line Package*") oder QFN- ("*Quad Flat no Leads Package*") Bauteil konzipiert sein. Alternativ zu der in Fig. 1 gezeigten Ausführungsvariante ist es ebenfalls denkbar, das Halbleiterbauteil 10 mitsamt dem Koppelelement 11 mittels Vergusskapselung 16 zu kapseln, so dass lediglich die galvanische Kontaktfläche 13 des Koppelelementes 11 zum Hohlleiter 12 hin von der Vergusskapselung ausgespart bleibt.

Als elektrische Kontaktierung des Halbleiterbauteils 10 zum Leadframe 16 fungieren bei der in Fig. 1 gezeigten Realisierungsvariante entsprechende Bondverbindungen 18. Als Substrat des gekapselten Halbleiterbauteils 10 dient bei der in Fig. 1 gezeigten Ausführungsvariante eine Leiterplatte 15 (im Sinne der Erfindung wäre es ebenfalls denkbar, das Halbleiterbauteil als *"Bare Die",* also ohne vorherige Kapselung direkt auf dem Leiterplattensubstrat 15 zu platzieren), wobei der Leadframe 17 des Halbleiterbauteils 10 und der Hohlleiter auf einer ersten Oberfläche 151 des Leiterplattensubstrates 15 befestigt sind.

In Fig. 1 ist das Koppelelement 11 auf derjenigen Oberfläche 101 des Halbleiterbauteils 10 angeordnet, die dem Leiterplattensubstrat 15 abgewandt ist. Das Koppelelement 15 kann prinzipiell baugleich zu dem Leiterplattensubstrat 15 aufgebaut sein, also basierend auf einem Kern aus einem Kunststoff oder einer Keramik bzw. einem Faserverbundwerkstoff. Lateral verlaufende elektrische Signal-, Masse- oder Leistungsführende Metallisierungslagen 110, 111 können gegebenenfalls strukturiert und im einfachsten Fall aus Kupfer (für Hochfrequenzpfade bietet Gold vorteilhaftere Eigenschaften) realisiert werden. Vertikale elektrische Durchkontaktierungen 112, 113 zwischen den Metallisierungslagen 110, 111 können als metallisierte Vias ausgelegt sein (vergleiche auch Fig. 2). Dabei können die Vias bspw. mittels des "*Glass-Prozesses*" gefertigt werden, so dass sie einen Durchmesser zwischen ca. 40 µm und 80 µm aufweisen. Zu einer effizienten Führung der Hochfrequenz-Signale s_{HF}, r_{HF} im Koppelelement 11 sind die Vias untereinander vorzugsweise mit einem Maximalabstand von der Hälfte, insbesondere einem Zehntel der Wellenlänge des Radar-Signals S_{HF}, R_{HF} beabstandet.

Korrespondierend zu dieser bekannten Aufbau- und Verbindungstechnologie kann auch die elektrische bzw. mechanische Kontaktierung 14 des Koppelelementes 11 an das Halbleiterbauteil 10 mittels bekannter Verfahren, wie bspw. Reflow-Löten eines Ball Grid Arrays, erfolgen. Alternativ zu der in Fig.1 gezeigten Realisierungsvariante wäre es ebenfalls denkbar, das Koppelelement 11 direkt als integralen Bestandteil der Vergusskapselung 16 auszulegen. Hierfür könnte das TPV-Verfahren ("*Through Package Via*") eingesetzt werden.

Bezüglich des Materials, aus dem der Hohlleiter 12 gefertigt zu sein hat, ist lediglich eine elektrisch leitfähige Innenwand erforderlich. Sofern also der Hohlleiter 12 nicht insgesamt aus einem metallischen Grundkörper gefertigt ist, kann er beispielsweise zumindest an der Innenwand, die zur Leitung der Radar-Signale S_{HF}, R_{HF} relevant ist, eine Metallbeschichtung, die bspw. per Sputtern oder PVD ("*Physical Vapor Deposition*") aufgetragen ist, aufweisen. Wie in Fig. 2 gezeigt ist, kann der Hohlleiter 12 als zusätzliche Kapselung des Halbleiterbauteils 10 und des Koppelelementes 11 fungieren, sofern der Hohlleiter 12 entsprechend deckelförmig ausgelegt ist. Hierzu kann der Hohlleiter 12 beispielsweise als Spritzguss-Teil mit entsprechend metallischer Innenbeschichtung gefertigt werden.

Die Querschnittsform (bspw. kreisförmig oder rechteckig) und die Abmessungen des Hohlleiter-Innenquerschnitts sind an die Frequenz bzw. die gewünschte Mode des auszusendenden/einzukoppelnden Radar-Signals S_{HF}, R_{HF} anzupassen. Bei Rechteckiger Auslegung können die zwei Kantenlängen des Rechteckes bspw. so ausgelegt werden, dass sie ein Kantenlängen-Verhältnis von 2:1 aufweisen. Dabei kann die erste Kantenlänge jeweils mit einem Drittel der Wellenlänge des Hochfrequenz-Signals S_{HF}, R_{HF} bemaßt werden, die zweite Kantenlänge kann entsprechend mit 2/3 der Wellenlänge ausgeführt werden. Die Wellenlänge bzw. die Frequenz von zumindest dem auszusendenden Radar-Signal S_{HF} durch das Halbleiterbauteil 10 festgelegt, da das Halbleiterbauteil 10 korrespondierende elektrische Hochfrequenz-Signale s_{HF}, auf deren Basis das Radar-Signal S_{HF} im Hohlleiter 12 abgestrahlt wird, erzeugt.

Im Sinne der Erfindung ist es ausschlaggebend, dass das elektrisch leitfähige Innere des Hohlleiters 12 einen galvanischen Kontakt 13 zu der relevanten Metallisierungslage 110 auf dem Koppelelement 11 ausbildet. Hierfür kann es bereits ausreichend sein, dass der galvanische Kontakt 13 allein über einen mechanischen Anpressdruck des Hohlleiters 12 auf das Koppelelement 11 erreicht wird. Somit ist eine separate elektrische Kontaktierung des Hohlleiters 12, bspw. durch Löten, bei der Fertigung des Hochfrequenzbausteins 1 rein optional. Wie in Fig. 2 gezeigt, kann ein solcher Anpressdruck dadurch bewirkt werden, indem der Hohlleiter 12 bspw. mittels Kleben, Schrauben oder per Steckverbindung auf dem Leiterplattensubstrat 15 befestigt wird. Dabei entsteht ein gewünschter, dauerhafter Anpressdruck, sofern der Hohlleiter 12 eine entsprechende vertikale Unterbemaßung aufweist. Dadurch, dass ein etwaiger Anpressdruck des Hohlleiters 12 nicht direkt auf das Halbleiterbauteil 10 wirkt, sondern durch das Koppelelement 11 abgebaut wird, ist das empfindliche Halbleiterbauteil 10 entsprechend vor der resultierenden mechanischen Spannung geschützt. Dabei ist der Schutz umso größer, je dicker das Koppelelement 11 ist. Daher empfiehlt sich eine Dicke des Koppelelementes von 200 µm oder mehr.

Die in Fig. 1 gezeigte Ausführungsvariante lässt sich vorzugsweise fertigen, wenn zunächst die elektrische bzw. mechanische Kontaktierung des Koppelelementes 11 an das Halbleiterbauteil 10 vorgenommen wird, bevor die galvanische Kontaktierung 13 des Hohlleiters 12 an das Koppelelement 11 erfolgt. Es versteht sich von selbst, dass das Halbleiterbauteil 10 (ggf. samt Koppelelement 11) bzw. der Leadframe 17 zunächst am Leiterplattensubstrat 15 befestigt werden muss, damit der Hohlleiter 12 zwecks galvanischer Kontaktierung 13 am Leiterplattensubstrat 15 befestigt werden kann. Der erfindungsgemäße galvanische Kontakt 13 zwischen dem Hohlleiter 12 und dem Koppelelement 11 wirkt sich insofern vorteilhaft aus, als das geringere Toleranzen bei der Bestückung des Hohlleiters 12 auf dem Koppelelement 11 erforderlich sind. Dabei kann der galvanische Kontakt 13 gewährt werden, indem die entsprechende erste Metallisierungslage 110 für die Hochfrequenz-Signale s_{HF}, r_{HF} auf dem Koppelelement 11 mit entsprechenden Toleranzen dimensioniert wird. Im Vergleich zum Stand der Technik ist es somit nicht erforderlich, genau definierte Spaltmaße zwischen Koppelelement 11 und Hohlleiter 12, die sich Mikrometer-genau nach der Mode und der Frequenz des Radar-Signals S_{HF}, R_{HF} richten, einzuhalten, um eine effiziente Abstrahlung/Einkopplung zu erzielen.

In Fig. 2 ist eine weitere Ausführungsvariante des erfindungsgemäßen Hochfrequenzbausteins 1 gezeigt: Im Gegensatz zu der in Fig. 1 gezeigten Ausführungsvariante sind das Halbleiterbauteil 10, das Koppelelement 11 und der Hohlleiter 12 nicht zusammen auf der ersten Oberfläche 151 des Leiterplattensubstrates 15 angeordnet. Vielmehr ist das Koppelelement 11 auf der ersten Oberfläche 151 des Leiterplattensubstrates 15 angeordnet, während das Halbleiterbauteil 10 in dieser Ausführungsvariante auf einer dem Leiterplattensubstrat 15 abgewandten Oberfläche 115 des Koppelelementes 11 angeordnet ist. Dabei kann das Halbleiterbauteil 10 mittels der in der Aufbau- und Verbindungstechnik bekannten "*Flip-Chip*" Montage über ein entsprechendes Ball-Grid-Array auf dem Koppelelement 11 kontaktiert werden.

Konträr zum Koppelelement 11 und dem Halbleiterbauteil 10 ist der Hohlleiter 12 auf einer zweiten, dem Koppelelement 11 bzw. dem Halbleiterbauteil 10 abgewandten Oberfläche 152 des Leiterplattensubstrates 15 befestigt. Dementsprechend ist der Hohlleiter 12 über eine Öffnung 153 in der Leiterplatte galvanisch mit dem Koppelelement 11 kontaktiert. Bei der in Fig. 2 gezeigten Ausführungsvariante des Hochfrequenzbausteins 1 ist es irrelevant, ob zwecks galvanischer Kontaktierung 13 des Hohlleiters 12 am Koppelelement 11 zunächst der Hohlleiter 12 am Leiterplattensubstrat 15 befestigt wird, oder ob hiervor das Koppelelement 11 am Leiterplattensubstrat 15 angebracht wird. Darüber hinaus ist es irrelevant, ob das Halbleiterbauteil 10 mit dem Koppelelement 11 kontaktiert wird, bevor oder nachdem das Koppelelement 11 am Leiterplattensubstrat 15 angebracht wird.

Wie aus Fig. 2 ersichtlich wird, werden im Gegensatz zu Fig. 1 im Koppelelement 11 des Hochfrequenzbausteins 1 neben den Hochfrequenz-Signalen s_{HF}, r_{HF} auch andere Signale wie Versorgungsspannungen, niederfrequente Signale, etc. zum Halbleiterbauteil 10 geführt. Als Aufbau- und Verbindungstechnologien zur Kontaktierung des Halbleiterbauteils 10, des Koppelelementes 11 und des Hohlleiters 12 kann bei der in Fig. 2 gezeigten Ausführungsvariante wiederum auf diejenigen Verfahren zurückgegriffen werden, die bereits in Zusammenhang mit der in Fig. 1 gezeigten Ausführungsvariante des Hochfrequenzbausteins 1 genannt sind. In diesem Zusammenhang wird aus Fig. 2 ersichtlich, dass die Vergusskapselung 16 lediglich das Halbleiterbauteil 10 komplett umschließt. Im Gegensatz zur gezeigten Darstellung wäre es ebenfalls denkbar, mittels der Vergusskapselung 16 auch das Koppelelement 11 komplett zu umschließen. Vorteilhaft an der in Fig. 2 gezeigten Ausführungsvariante des Hochfrequenzbausteins 1 ist dessen potentiell flache Bauweise.

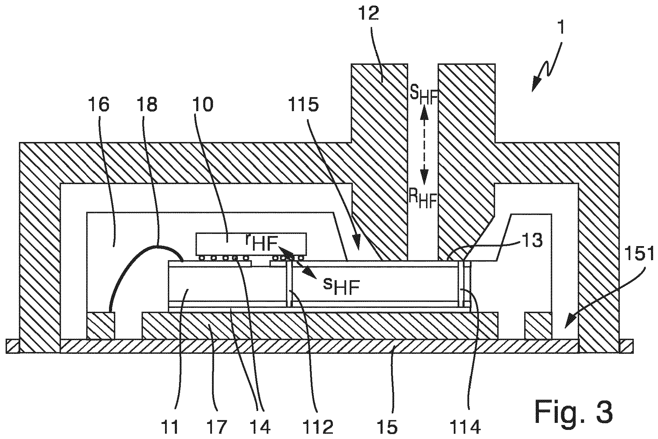

Fig. 3 zeigt eine dritte Ausführungsvariante des erfindungsgemäßen Hochfrequenzbausteins 1. Bei dieser Ausführungsvariante sind im Gegensatz zu Fig. 1 nicht das Halbleiterbauteil 10, sondern das Koppelelement 11 und der Hohlleiter 12 zusammen auf der ersten Oberfläche 151 des Leiterplattensubstrates 15 angeordnet. Das Halbleiterbauteil 10 ist, wie bei der Ausführungsvariante gemäß Fig. 2, auf der dem Leiterplattensubstrat 15 abgewandten Oberfläche 115 des Koppelelementes 11 angeordnet. Da das Halbleiterbauteil 10 also nicht direkt auf dem Leiterplattensubstrat 15 angeordnet ist, sondern oberhalb des Koppelelementes 11, werden bei der in Fig. 3 gezeigten Ausführungsvariante im Koppelelement 11 neben den Hochfrequenz-Signalen s_{HF}, r_{HF} auch alle anderen Signale wie Versorgungsspannungen, niederfrequente Signale, etc. zum Halbleiterbauteil 10 geführt. Analog zu der in Fig. 2 gezeigten Ausführungsvariante des Hochfrequenzbausteins kann auch in Fig. 3 das Halbleiterbauteil 10 per Flip-Chip Montage auf dem Koppelelement 11 kontaktiert werden.

Die Vergusskapselung 16 kann dabei so angebracht werden, dass das Halbleiterbauteil 10 komplett gekapselt ist. Dabei ist die Vergusskapselung 16 allerdings wiederum so auszulegen, dass die Kontaktfläche des Koppelelements 11 zur galvanischen Kontaktierung 13 des Hohlleiters 12 vom Verguss 16 ausgespart bleibt. Neben dem Vorteil, dass das empfindlichste aller Bauteile, nämlich das Halbleiterbauteil 10 komplett gekapselt werden kann, weist die Ausführungsvariante gemäß Fig. 3 den wesentlichen Vorteil auf, dass bei der galvanischen Kontaktierung 13 des Hohlleiters 12 am Koppelelement 11 keine ungewollte Spannung im Halbleiterbauteil 10 induziert werden kann. Darüber hinaus ist im Vergleich zu der in Fig. 2 gezeigten Ausführungsvariante keine Öffnung 153 im Leiterplattensubstrat 15 erforderlich.

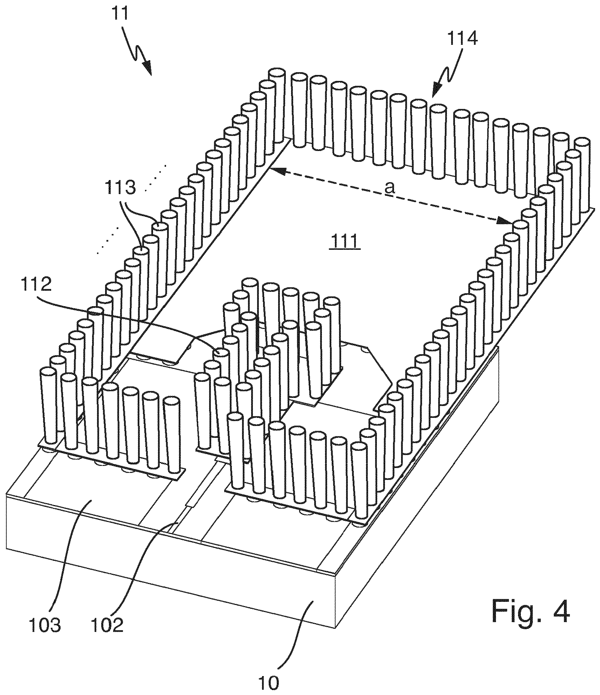

Fig. 4 zeigt eine Detailansicht des Koppelelementes 11 zur Kopplung der Radar-Signale S_{HF}, R_{HF} zwischen dem Halbleiterbauteil 10 und dem Hohlleiter 12. In der gezeigten Ausführungsform basiert das Koppelelement 12 auf einem Substrat wie beispielsweise Glas, Kunststoff, Keramik oder einem Verbundwerkstoff. Somit fungiert das Koppelelement als SIW ("*Substrat Integrierter Wellenleiter*"). Zur Übertragung der Radar-Signale S_{HF}, R_{HF} zwischen dem Halbleiterbauteil 10 und dem Hohlleiter 12 umfasst das Koppelelement 11 eine erste, obere Metallisierungslage 110 und eine zweite, untere Metallisierungslage 111, mittels der der galvanische Kontakt 13 zum Hohlleiter hergestellt wird. Dabei ist die obere, erste Metallisierungslage 110 des Koppelelementes 11 in Fig. 4 ausgeblendet.

Daher sind in Fig. 4 erste Durchkontaktierungen 112 erkennbar, die den elektrischen Kontakt der oberen, signalführenden Metallisierungslage 110 mit einer entsprechenden Mikrostreifenleitung 102 auf dem Halbeiterbauteil 10 (ggf. über ein entsprechendes Ball-Grid-Array, vergleiche Fig. 2 und Fig. 3) herstellen. Da der elektrische Pfad der ersten Durchkontaktierungen 112 die Ebene der unteren, zweiten Metallisierungslage 111 kreuzt, ist die untere Metallisierungslage 111 entsprechend strukturiert, so dass die untere Metallisierungslage 111 elektrisch von den ersten Durchkontaktierungen 112 isoliert ist. Weiterhin sichtbar sind in Fig. 4 zweite Durchkontaktierungen 113, welche die elektrische Verbindung der ersten, oberen Metallisierungslage 110 zur unteren, zweiten Metallisierungslage 111 herstellen.

Wie in Fig. 4 zu erkennen ist, sind die ersten Durchkontaktierungen 112 in Bezug zu den zweiten Durchkontaktierungen 113 entlang einer inneren, quasi geschlossenen Kontur in Form eines T's angeordnet. Hierdurch wird bewirkt, dass die Hochfrequenz-Signale s_{HF}, r_{HF} im Koppelelement 11 vorwiegend in eine definierte Grund-Mode umgewandelt werden. Beispielsweise kann die Form bzw. die Größe der inneren Kontur so optimiert werden, dass vorwiegend die TE₁₀-Mode ausbreitungsfähig ist. Die Optimierung kann bspw. auf Basis nummerischer Simulation erfolgen.

In Bezug zu den ersten Durchkontaktierungen 112 sind die zweiten Durchkontaktierungen 113 entlang einer zweiten, außenliegenden Kontur in Form eines Rechteckes angeordnet. Dabei haben die äußeren Durchkontaktierungen 113 zwei Funktionen: Zum einen sind die auszusendenden Radar-Signale S_{HF} aus der Ebene der Metallisierungslagen 110, 111 in Richtung der Achse des Hohlleiters 12 zu richten bzw. die eintreffenden Radar-Signale R_{HF} aus dieser Richtung in die Ebene der Metallisierungslagen 110, 112 zu richten. Erreicht wird dies bei der in Fig. 4 gezeigten Ausführungsvariante des Koppelelementes 11 insbesondere durch einen geradlinigen Teilbereich 114 der äußeren Kontur der zweiten Durchkontaktierungen 113. Da der geradlinige Teilbereich 114 nach Montage des Hochfrequenzbausteins 1 in Bezug zur ersten Kontur bzw. den ersten Durchkontaktierungen 112 hinter dem Hohlleiter 12 angeordnet ist (siehe hierzu auch Fig.3), werden die Radar-Signale S_{HF}, R_{HF} hierdurch entsprechend um 90° gen Hohlleiter 12 bzw. in die Ebene der Metallisierungslagen 110, 111 umgelenkt. Entscheidend für diese Wirkung ist, dass der geradlinige Teilbereich 114 der äußeren Kontur in Bezug zu den ersten Durchkontaktierungen 112 nicht vor derjenigen Innenwand (bzw. deren Verlängerung) des Hohlleiters 12 angeordnet ist, die der inneren Kontur zugewandt ist.

Eine zweite Funktion der äußeren Durchkontaktierungen 113 ist es, die Radar-Signale S_{HF}, R_{HF} lateral im Koppelelement 11 zwischen den ersten Durchkontaktierungen 112 und dem geradlinigen Teilbereich 114 zu führen. Daher weist die rechteckige, zweite Kontur bzw. der geradlinige Teilbereich eine definierte Kantenlänge a auf: Hierzu ist die Kantenlänge a entsprechend der Wellenlänge der Radar-Signale S_{HF}, R_{HF} und der Mode, die von den ersten Durchkontaktierungen 112 ausgebildet wird, auszulegen. Hierfür ist es geeignet, die Kantenlänge a mit ca. zwei Dritteln der Wellenlänge der Radar-Signale S_{HF}, R_{HF} zu bemessen. Zur elektrischen Kontaktierung der unteren, masseführenden Metallisierungslage 111 des Koppelelementes 11 mit einer entsprechenden Masselage 103 auf dem Halbleiterbauteil 10 ist im Überlappungsbereich zwischen dem Halbleiterbauteil 10 und dem Koppelelement 11 ein Ball Grid Array unterhalb der zweiten Durchkontaktierungen 113 vorgesehen, wie aus Fig. 4 hervorgeht.

Damit die Radar-Signale S_{HF}, R_{HF} zwischen dem Halbleiterbauteil 10 und dem Hohlleiter 12 effizient gekoppelt werden, ist es neben der Auslegung der zwei Konturen ebenfalls sinnvoll, den Abstand der einzelnen Durchkontaktierungen 112, 113 zueinander möglichst eng auszulegen. Daher ist es vorteilhaft, den Abstand der einzelnen Durchkontaktierungen 112, 113 zueinander mit höchstens der Hälfte, insbesondere einem Zehntel der Wellenlänge des Radar-Signals S_{HF}, R_{HF} zu bemaßen.

Um den erfindungsgemäßen Hochfrequenzbaustein 1 zur Radar-basierten Abstandsmessung einsetzen zu können, muss das Halbleiterbauteil 10 ausgelegt sein, je nach verwendetem Messprinzip, wie FMCW oder dem Puls-Laufzeit-Prinzip, die elektrischen Hochfrequenz-Signale s_{HF}, r_{HF} entsprechend zu erzeugen bzw. zu verarbeiten: Bei Implementierung des FMCW-Prinzips kann das auszusendende Hochfrequenz-Signal s_{HF} beispielsweise mittels eines Oszillators (zum Beispiel als "*Voltage Controlled Oscillator*" ausgelegt), der per PLL ("*Phase Locked Loop*") geregelt ist, erzeugt werden. Zur Signalverarbeitung kann das Halbleiterbauteil 10 empfangsseitig einen Mischer zum Mischen des momentan auszusendenden Hochfrequenz-Signals s_{HF} mit dem aktuell empfangenen Hochfrequenz-Signal r_{HF} umfassen. Dies wird genutzt, um aus dem gemischten Signal in einem entsprechenden Schaltungsblock des Halbleiterbauteils 10 beispielsweise mittels einer FFT ("*Fast Fourier Transformation*") über die Frequenz des gemischten Signals den Abstand ermitteln zu können. Sofern das Halbleiterbauteil 10 entsprechend ausgelegt ist und eine an den Hohlleiter 12 anschließende Antenne vorgesehen ist, kann der erfindungsgemäße Hochfrequenzbaustein 1 in einem Abstandsmessgerät, wie einem Füllstandsmessgerät 2 eingesetzt werden.

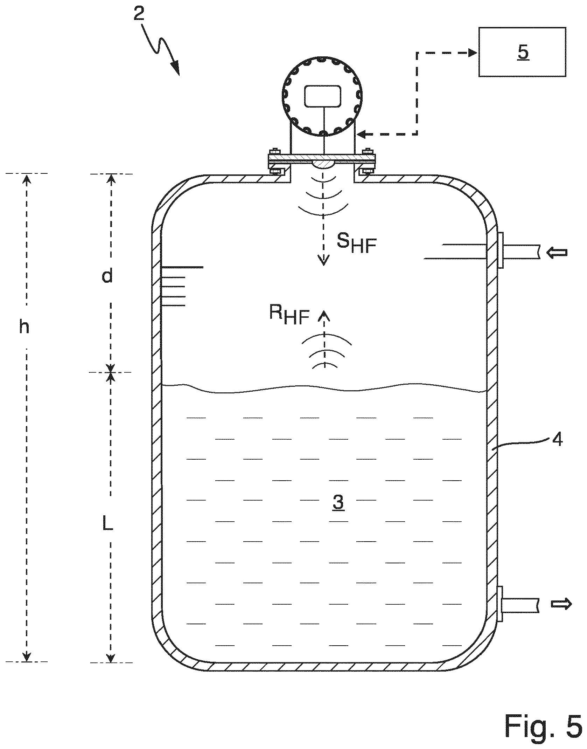

In Fig. 5 ist eine mögliche Verwendung des erfindungsgemäßen Hochfrequenzbausteins 1 in einem Füllstandsmessgerät 2 gezeigt. Hierbei dient das Füllstandsmessgerät 2 zur Messung des Füllstandes L eines in einem Behälter 4 befindlichen Füllgutes 3. Bei dem Füllgut 3 kann es sich einerseits um Flüssigkeiten wie beispielsweise Raffinerieprodukte, etwa Öle oder Flüssiggase, (Ab-)Wasser, Getränke oder pharmazeutische Komponenten handeln; Es kann sich aber auch um Feststoffe wie Kies, Saatgut oder Vergleichbarem handeln.

Zur Füllstands-Messung ist das Füllstandsmessgerät 2 in einer bekannten Einbauhöhe h oberhalb des Füllgutes 3 am Behälter 4 angebracht. Dabei ist das Füllstandsmessgerät 2 so am Behälter 4 ausgerichtet, dass mittels des Hochfrequenzbausteins 1 Radar-Signale S_{HF} in Richtung der Oberfläche des Füllgutes 3 ausgesendet werden. Hierfür koppelt der Hochfrequenzbaustein 1 das als Radar-Signal S_{HF} auszusendende Hochfrequenz-Signal s_{HF} in die Antenne des Füllstandsmessgerätes 2 ein. Nach Reflektion an der Füllgut-Oberfläche wird das reflektierte Radar-Signal R_{HF} von der Antenne empfangen und entsprechend wieder als Hochfrequenz-Signal r_{HF} dem Hochfrequenzbaustein 1 zugeführt. Dabei empfängt das Füllstandsmessgerät 2 das reflektierte Radar-Signal R_{HF} in Abhängigkeit des Abstandes d = h - L zur Füllgut-Oberfläche. Da die Einbauhöhe h bekannt ist (je nach Prozess-Anlage kann die Einbauhöhe h bis zu mehr als 100 m betragen), lässt sich mittels obiger Formel anhand des gemessenen Abstandes d der Füllstand L bestimmen. Bei Implementierung des Puls-Laufzeit Verfahrens wird der Abstand d auf Basis der gemessenen Puls-Laufzeit t des ausgesendeten, pulsförmigen Radar-Signals S_{HF} berechnet. Im Falle des FMCW-Verfahrens wird der Abstand d über die momentane Differenz-Frequenz zwischen dem ausgesendeten, frequenzmodulierten Radar-Signal S_{HF} und dem empfangenen, reflektierten Radar-Signal R_{HF} ermittelt.

In der Regel ist das Füllstandsmessgerät 2 über ein Bussystem, etwa "PROFIBUS", "HART", "Wireless HART" oder "Ethernet" mit einer übergeordneten Einheit 5, beispielsweise einem Prozessleitsystem oder einer per Internet ansteuerbaren Datenbank, verbunden. Hierüber können zum einen Informationen über den Betriebszustand des Füllstandsmessgerätes 2 kommuniziert werden. Es können auch Informationen über den Füllstand L übermittelt werden, um gegebenenfalls die am Behälter 4 vorhandenen Zu- oder Abflüsse zu steuern.

Da das Füllstandsmessgerät 2 auf dem erfindungsgemäßen Hochfrequenzbaustein 1 basiert, profitiert das Füllstandsmessgerät 2 von dem geringen Leistungsverbrauch des Hochfrequenzbaustein 1 sowie den Radarfrequenzen von potentiell über 100 GHz. Dabei äußert sich die hohe Radar-Frequenz vor allem in einer kompakt auslegbaren Antenne bzw. dem entsprechend engen Strahlkegel des Radar-Signals S_{HF} sowie einem hohen Auflösungsvermögen des Füllstandes L im sub-Millimeterbereich.

### Bezugszeichenliste

| | | | |
|---|---|---|---|
| 1 | Hochfrequenzbaustein | | |
| 2 | Füllstandsmessgerät | | |
| 3 | Behälter | | |
| 4 | Füllgut | | |
| 5 | Übergeordnete Einheit | | |
| 10 | Halbleiterbauteil | | |
| 11 | Koppelelement | | |
| 12 | Hohlleiter | | |
| 13 | Galvanischer Kontakt | | |
| 14 | Lötverbindung | | |
| 15 | Leiterplattensubstrat | | |
| 16 | Vergusskapselung | | |
| 17 | Leadframe | | |
| 18 | Bondverbindung | | |
| 101 | Oberfläche des Halbleiterbauteils | | |
| 102 | Mikrostreifenleitung | | |
| 103 | Masse-Lage | | |
| 110 | Erste Metallisierungslage | | |
| 111 | Zweite Metallisierungslage | | |
| 112 | Erste elektrische Durchkontaktierungen | | |
| 113 | Zweite elektrische Durchkontaktierungen | | |
| 114 | Geradliniger Teilbereich der äußeren Kontur | | |
| 115 | Oberfläche des Koppelelementes | | |
| 151 | Erste Oberfläche des Leiterplattensubstrates | | |
| 152 | Zweite Oberfläche des Leiterplattensubstrates | | |
| 153 | Öffnung im Leiterplattensubstrat | | |
| a | Kantenlänge | | |
| d | Entfernung | | |
| h | Einbauhöhe | S_{HF} | Radar-Signal |
| L | Füllstand | s_{HF}, r_{HF} | Hochfrequenz-Signale |
| R_{HF} | Empfangssignal | | |

## Patentansprüche

1. Hochfrequenzbaustein, umfassend:
- ein Halbleiterbauteil (10), das ausgelegt ist, elektrische Hochfrequenz-Signale (s_{HF}, r_{HF}) zu erzeugen und/oder zu verarbeiten,
- einen Hohlleiter (12),
- ein Koppelelement (11), das elektrisch mit dem Halbleiterbauteil (10) und galvanisch mit dem Hohlleiter (12) kontaktiert ist, um die Hochfrequenz-Signale (s_{HF}) als Radar-Signale (S_{HF}) in den Hohlleiter (12) einzukoppeln, und/oder um Radar-Signale (R_{HF}) aus dem Hohlleiter (12) als elektrische Signale (r_{HF}) in das Halbleiterbauteil (10) einzukoppeln, mit
∘ einer ersten Metallisierungslage (110),
∘ einer zweiten Metallisierungslage (111),
∘ ersten elektrischen Durchkontaktierungen (112), die das Halbleiterbauteil (10) mit der ersten Metallisierungslage (110) kontaktieren, und
∘ zweiten elektrischen Durchkontaktierungen (113) zwischen der ersten Metallisierungslage (110) und der zweiten Metallisierungslage (111),
- wobei die elektrischen Durchkontaktierungen (112, 113) als metallisierte Vias ausgelegt sind,
wobei die ersten Durchkontaktierungen (112) derart entlang einer inneren, quasi geschlossenen Kontur angeordnet sind, dass die Radar-Signale (S_{HF}, R_{HF}) im Koppelelement (11) vorwiegend in der TE₁₀-Mode geleitet werden, und wobei die zweiten Durchkontaktierungen (113) in Bezug zur inneren Kontur derart entlang einer äußeren, quasi geschlossenen Kontur angeordnet sind, dass die Hochfrequenz-Signale (s_{HF}, r_{HF}) lateral im Koppelelement (11) geführt und um 90° in Richtung der Achse des Hohlleiters (12) und aus dieser Richtung um 90° in die Ebene der Metallisierungslagen (110, 111) umgelenkt werden.

2. Hochfrequenzbaustein nach Anspruch 1, wobei das Koppelelement (11) eine Dicke von zumindest 200 µm aufweist.

3. Hochfrequenzbaustein nach einem der vorhergehenden Ansprüche, wobei das Halbleiterbauteil (10) und das Koppelelement (11) zur Übertragung der Hochfrequenz-Signale (s_{HF}, r_{HF}) mittels einer Lötverbindung (14), insbesondere einem Ball Grid Array, kontaktiert sind.

4. Hochfrequenzbaustein nach einem der vorhergehenden Ansprüche, wobei das Halbleiterbauteil (10) mit einer Vergusskapselung (16), gekapselt ist.

5. Hochfrequenzbaustein nach Anspruch 4, wobei das Halbeiterbauteil (10) derart gekapselt ist, dass es an einer Kontaktfläche zum Koppelelement (11) hin frei von Verguss (16) ist, und/oder dass das Koppelelement (11) an der galvanischen Kontaktfläche (13) zum Hohlleiter hin frei von Verguss (16) ist.

6. Hochfrequenzbaustein nach einem der vorhergehenden Ansprüche, wobei das Halbleiterbauteil (10) und der Hohlleiter (12) auf einer ersten Oberfläche (151) eines Leiterplattensubstrates (15) des Hochfrequenzbausteins angeordnet sind, und wobei das Koppelelement (11) auf einer dem Leiterplattensubstrat (15) abgewandten Oberfläche (101) des Halbleiterbauteils 10) angeordnet ist.

7. Hochfrequenzbaustein nach einem der Ansprüche 1 bis 5, wobei das Koppelelement (11) auf der ersten Oberfläche (151) eines Leiterplattensubstrates (15) des Hochfrequenzbausteins angeordnet ist, wobei das Halbleiterbauteil (10) auf einer dem Leiterplattensubstrat (15) abgewandten Oberfläche (115) des Koppelelementes (11) angeordnet ist, und wobei der Hohlleiter (12) auf einer zweiten, dem Koppelelement (11) abgewandten Oberfläche (152) des Leiterplattensubstrates (15) befestigt ist, und wobei der Hohlleiter (12) über eine Öffnung (153) in der Leiterplatte (15) mit dem Koppelelement (11) kontaktiert ist.

8. Hochfrequenzbaustein nach einem der Ansprüche 1 bis 5, wobei das Koppelelement (11) und der Hohlleiter (12) auf der ersten Oberfläche (151) eines Leiterplattensubstrates (15) des Hochfrequenzbausteins angeordnet sind, und wobei das Halbleiterbauteil (10) auf einer dem Leiterplattensubstrat (15) abgewandten Oberfläche (113) des Koppelelementes (11) angeordnet ist.

9. Hochfrequenzbaustein nach einem der vorhergehenden Ansprüche, wobei das Halbleiterbauteil (10) ausgelegt ist, das Hochfrequenz-Signal (s_{HF}) mit einer Frequenz von zumindest 75 GHz zu erzeugen.

10. Radar-basiertes Abstandsmessgerät zur Bestimmung eines Abstandes (d) zu einem Messobjekt, umfassend:
- einen Hochfrequenzbaustein (10) nach einem der vorhergehenden Ansprüche,
- eine an den Hohlleiter (12) anschließende Antenne, die ausgelegt ist, die Radar-Signale (S_{HF}, R_{HF}) in Richtung des Messobjektes (3) auszusenden und nach Reflexion am Messobjekt (3) zu empfangen,
wobei das Halbleiterbauteil (10) ausgelegt ist, zumindest anhand der reflektierten Radar-Signale (R_{HF}) den Abstand (d) zu bestimmen.

11. Verwendung des Abstandsmessgerätes nach Anspruch 10 als Füllstandsmessgerät, das zur Messung des Füllstandes (L) eines in einem Behälter (4) befindlichen Füllgutes (3) ausgelegt ist.

12. Verfahren zur Fertigung eines Hochfrequenzbausteins nach einem der Ansprüche 1 bis 9, folgende Verfahrensschritte umfassend:
- elektrische und mechanische Kontaktierung des Koppelelementes (11) an dem Halbleiterbauteil (10),
- galvanische Kontaktierung des Hohlleiters (12) am Koppelelement (11).

## Claims

1. A high-frequency module, comprising:
- A semiconductor component (10) which is configured to generate and/or process electrical high-frequency signals (s_{HF}, r_{HF}), a waveguide (12),
- a coupling element (11) which is electrically contacted with the semiconductor component (10) and galvanically contacted with the waveguide (12) in order to couple the high-frequency signals (s_{HF}) into the waveguide (12) as radar signals (s_{HF}) and/or to couple radar signals (r_{HF}) from the waveguide (12) into the semiconductor component (10) as electrical signals (r_{HF}), with
∘ a first metalization layer (110),
∘ a second metalization layer (111),
∘ first electrical plated through-holes (112) which contact the semiconductor component (10) with the first metalization layer (110), and
∘ second electrical plated through-holes (113) between the first metalization layer (110) and the second metalization layer (111),
- wherein the electrical plated through-holes (112, 113) are configured as metalized vias, wherein the first plated through-holes (112) are arranged along an internal, almost closed contour in such a way that the radar signals (s_{HF}, r_{HF}) in the coupling element (11) are mainly conducted in TE10 mode, and wherein the second plated through-holes (113) are arranged relative to the internal contour along an external, almost closed contour in such a way that the high-frequency signals (s_{HF}, r_{HF}) are conducted laterally in the coupling element (11) and are diverted by 90° in the direction of the axis of the waveguide (12) and from this direction by 90° into the plane of the metalization layers (110, 111).

2. The high-frequency module as claimed in claim 1, wherein the coupling element (11) has a thickness of at least 200 µm.

3. The high-frequency module as claimed in one of the preceding claims, wherein the semiconductor component (10) and the coupling element (11) for transmitting the high-frequency signals (s_{HF}, r_{HF}) are contacted by means of a soldered connection (14), in particular a ball grid array.

4. The high-frequency module as claimed in one of the preceding claims, wherein the semiconductor component (10) is encapsulated using a potting compound (16).

5. The high-frequency module as claimed in claim 4, wherein the semiconductor component (10) is encapsulated in such a way that it is free from potting compound (16) at a contact surface toward the coupling element (11), and/or that the coupling element (11) is free from potting compound (16) at the galvanic contact surface (13) toward the waveguide.

6. The high-frequency module as claimed in one of the preceding claims, wherein the semiconductor component (10) and the waveguide (12) are arranged on a first surface (151) of a PCB substrate (15) of the high-frequency module, and wherein the coupling element (11) is arranged on a surface (101) of the semiconductor component (10) facing away from the PCB substrate (15).

7. The high-frequency module as claimed in one of claims 1 to 5, wherein the coupling element (11) is arranged on the first surface (151) of a PCB substrate (15) of the high-frequency module,
wherein the semiconductor component (10) is arranged on a surface (115) of the coupling element (11) facing away from the PCB substrate (15), and wherein the waveguide (12) is mounted on a second surface (152) of the PCB substrate (15) facing away from the coupling element (11), and wherein the waveguide (12) is contacted with the coupling element (11) via an opening (153) in the PCB (15).

8. The high-frequency module as claimed in one of claims 1 to 5, wherein the coupling element (11) and the waveguide (12) are arranged on the first surface (151) of a PCB substrate (15) of the high-frequency module, and wherein the semiconductor component (10) is arranged on a surface (113) of the coupling element (11) facing away from the PCB substrate (15).

9. The high-frequency module as claimed in one of the preceding claims,
wherein the semiconductor component (10) is configured to generate the high-frequency signal (s_{HF}) with a frequency of at least 75 GHz.

10. A radar-based distance measuring device for determining a distance (d) from a measurement object, comprising:
- A high-frequency module (10) as claimed in one of the preceding claims,
- an antenna connected to the waveguide (12), which is configured to send the radar signals (s_{HF}, r_{HF}) in the direction of the measurement object (3) and to receive them after reflection at the measurement object (3), wherein the semiconductor component (10) is configured to determine the distance (d) on the basis of the reflected radar signals (r_{HF}) as a minimum.

11. The use of the distance measuring device as claimed in claim 10 as a fill level meter which is configured to measure the fill level (L) of a filling material (3) located in a container (4).

12. A method for manufacturing a high-frequency module as claimed in one of claims 1 to 9, comprising the following process steps:
- Electrical and mechanical contacting of the coupling element (11) on the semiconductor component (10),
- galvanic contacting of the waveguide (12) on the coupling element (11).

## Revendications

1. Composant haute fréquence, comprenant :
- un composant semi-conducteur (10), lequel est conçu pour générer et/ou traiter des signaux électriques haute fréquence (s_{HF}, r_{HF}),
- un guide d'ondes (12),
- un élément de couplage (11), lequel est en contact électrique avec le composant semi-conducteur (10) et lequel est en contact galvanique avec le guide d'ondes (12), lequel élément de couplage est destiné à coupler les signaux haute fréquence (s_{HF}) en tant que signaux radar (S_{HF}) dans le guide d'ondes (12) et/ou à coupler les signaux radar (R_{HF}) du guide d'ondes (12) en tant que signaux électriques (r_{HF}) dans le composant semi-conducteur (10), avec
∘ une première couche de métallisation (110),
∘ une deuxième couche de métallisation (111)
∘ des premiers trous d'interconnexion électriques (112) qui mettent en contact le composant semi-conducteur (10) avec la première couche de métallisation (110), et
∘ des deuxièmes trous d'interconnexion électriques (113) entre la première couche de métallisation (110) et la deuxième couche de métallisation (111),
- les trous d'interconnexion électriques (112, 113) étant conçus comme des vias métallisés, les premiers trous d'interconnexion (112) étant disposés le long d'un contour intérieur quasi fermé, de telle sorte que les signaux radar (S_{HF}, R_{HF}) sont conduits dans l'élément de couplage (11) principalement dans le mode TE₁₀, et les deuxièmes trous d'interconnexion (113) étant disposés par rapport au contour intérieur le long d'un contour extérieur quasi fermé, de telle sorte que les signaux haute fréquence (s_{HF}, r_{HF}) sont guidés latéralement dans l'élément de couplage (11) et déviés de 90° en direction de l'axe du guide d'ondes (12) et de 90° à partir de cette direction dans le plan des couches de métallisation (110, 111).

2. Composant haute fréquence selon la revendication 1, pour lequel l'élément de couplage (11) présente une épaisseur d'au moins 200 µm.

3. Composant haute fréquence selon l'une des revendications précédentes, pour lequel le composant semi-conducteur (10) et l'élément de couplage (11) sont mis en contact pour la transmission des signaux haute fréquence (s_{HF}, r_{HF}) au moyen d'une connexion soudée (14), notamment une matrice de billes (« Ball Grid Array »).

4. Composant haute fréquence selon l'une des revendications précédentes, pour lequel le composant semi-conducteur (10) est encapsulé avec un enrobage (16).

5. Composant haute fréquence selon la revendication 4, pour lequel le composant semi-conducteur (10) est encapsulé de telle sorte qu'il est exempt d'enrobage (16) au niveau d'une surface de contact vers l'élément de couplage (11) et/ou que l'élément de couplage (11) est exempt d'enrobage (16) au niveau de la surface de contact galvanique (13) vers le guide d'ondes.

6. Composant haute fréquence selon l'une des revendications précédentes, pour lequel le composant semi-conducteur (10) et le guide d'ondes (12) sont disposés sur une première surface (151) d'un substrat de carte de circuit imprimé (15) du composant haute fréquence, et l'élément de couplage (11) étant disposé sur une surface (101) du composant semi-conducteur (10), laquelle surface est opposée au substrat de carte de circuit imprimé (15).

7. Composant haute fréquence selon l'une des revendications 1 à 5, pour lequel l'élément de couplage (11) est disposé sur la première surface (151) d'un substrat de carte de circuit imprimé (15) du composant haute fréquence,
le composant semi-conducteur (10) étant disposé sur une surface (115) de l'élément de couplage (11) opposée au substrat de carte de circuit imprimé (15), et le guide d'ondes (12) étant fixé sur une deuxième surface (152) du substrat de carte de circuit imprimé (15), laquelle surface est opposée à l'élément de couplage (11), et le guide d'ondes (12) étant en contact avec l'élément de couplage (11) par une ouverture (153) dans la carte de circuit imprimé (15).

8. Composant haute fréquence selon l'une des revendications 1 à 5, pour lequel l'élément de couplage (11) et le guide d'ondes (12) sont disposés sur la première surface (151) d'un substrat de carte de circuit imprimé (15) du composant haute fréquence, et le composant semi-conducteur (10) étant disposé sur une surface (113) de l'élément de couplage (11), laquelle surface est opposée au substrat de carte de circuit imprimé (15).

9. Composant haute fréquence selon l'une des revendications précédentes, pour lequel le composant semi-conducteur (10) est conçu pour générer le signal radiofréquence (s_{HF}) à une fréquence d'au moins 75 GHz.

10. Appareil de mesure de distance basé sur un radar, lequel appareil est destiné à la détermination d'une distance (d) par rapport à un objet de mesure, lequel appareil comprend :
- un composant haute fréquence (10) selon l'une des revendications précédentes,
- une antenne raccordée au guide d'ondes (12), laquelle antenne est conçue pour émettre les signaux radar (S_{HF}, R_{HF}) en direction de l'objet de mesure (3) et pour les recevoir après réflexion sur l'objet de mesure (3),
le composant semi-conducteur (10) étant conçu pour déterminer la distance (d) au moins à l'aide des signaux radar réfléchis (R_{HF}).

11. Utilisation de l'appareil de mesure de distance selon la revendication 10 en tant qu'appareil de mesure de niveau, lequel appareil est conçu pour la mesure du niveau (L) d'un produit (3) se trouvant dans un réservoir (4).

12. Procédé destiné à la fabrication d'un composant haute fréquence selon l'une des revendications 1 à 9, lequel procédé comprend les étapes suivantes :
- mise en contact électrique et mécanique de l'élément de couplage (11) sur le composant semi-conducteur (10),
- mise en contact galvanique du guide d'ondes (12) sur l'élément de couplage (11).
